# FASCICULE DE BREVET EUROPEEN

(11) **EP 0 354 841 B1**
(45) Date de publication et mention de la délivrance du brevet: **31.03.1993**
(21) Numéro de dépôt: 89402236.7
(22) Date de dépôt: 08.08.1989
(51) Int. Cl.: G01R 27/16

(54) **Dispositif de surveillance du deséquilibre de la puissance électrique appelée sur les lignes conductrices d'un réseau électrique alternatif ou d'une installation intérieure triphasé**
Überwachungsanordnung für die Unausgeglichenheit der elektrischen Leistung in einem elektrischen Netz oder einer Installation
Appliance for monitoring the electric power disequilibrium in electric network lines or in an internal triphase installation

(30) Priorité: 09.08.1988 FR 8810739
(43) Date de publication de la demande: 14.02.1990
(73) Titulaire: ELECTRICITE DE FRANCE Service National, 75008 Paris (FR)
(72) Inventeur: Feron, Paul, F-31000 Toulouse (FR)
(74) Mandataire: Mongrédien, André

(56) Documents cités:
- FR-A- 2 206 507
- FR-A- 2 557 391
- PATENT ABSTRACTS OF JAPAN, vol. 6, no. 137 (P-130)[1015], 24 juillet 1982; & JP-A-57 59 175 (TOKYO SHIBAURA DENKI K.K.) 09-04-1982

## Description

La présente invention concerne un dispositif de surveillance du déséquilibre de la puissance électrique appelée sur les lignes conductrices d'un réseau alternatif triphasé. Elle s'applique à tous les réseaux triphasés qui desservent des appareils de type monophasé, en nombre et puissance variables.

Dans les réseaux électriques, qui desservent des appareils monophasés, il arrive que des déséquilibres importants de puissance électrique appelée apparaîssent lorsque la valeur du courant circulant dans une des lignes de phase de ce réseau, devient beaucoup plus importante que les valeurs des courants circulant dans les autres lignes de phases. C'est par exemple le cas lorsque le réseau alimente des appareils monophasés et qu'une majorité de ces appareils consomme un courant important, à un instant déterminé, sur l'une des phases du réseau. Lorsque ce déséquilibre devient trop important, les protections installées pour se prémunir contre les surcharges peuvent fonctionner, et les chutes de tension peuvent atteindre, pour une partie des usagers et des matériels des valeurs prohibitives, alors qu'un meilleur état d'équilibre permettrait d'éviter ces inconvénients.

Il n'existe pas actuellement de dispositif simple et peu onéreux de surveillance du déséquilibre de la puissance électrique appelée sur les lignes de différentes phases d'un réseau électrique ou d'une installation alternative triphasée.

Cette absence est préjudiciable aux distributeurs d'électricité puisqu'ils ne peuvent, dans l'ignorance de l'intensité maximale appelée sur chaque ligne de phase, limiter cette intensité maximale par une répartition plus judicieuse des charges ou appareils reliés à chacune des lignes de phase.

Il en résulte que le coût de distribution d'énergie électrique qui inclut des frais de surveillance de dépannage, d'entretien et de renouvellement des installations, des frais d'interruption de services et des pertes électriques dues à l'irrégularité des tensions, pourrait être réduit par une meilleure connaissance du taux de déséquilibré de puissance électrique appelée.

La présente invention a pour but de remédier à ces inconvénients et notamment de réaliser un dispositif de détection du déséquilibre de la puissance électrique appelée sur les lignes conductrices d'un réseau triphasé, qui permet, grâce à une meilleure connaissance du déséquilibre de ce réseau, de mieux répartir les charges sur les différentes lignes de phase de celui-ci ; on évite ainsi des interruptions de distribution dues à une surintensité dans l'une des lignes de phase, grâce à une meilleure répartition, notamment des appareils monophasés branchés sur ce réseau, de façon à obtenir une meilleure répartition de la puissance électrique appelée sur chacune des lignes de phase.

Il est à noter que le déséquilibre de la puissance appelée sur le réseau peut être permanent. Ce type de déséquilibre est dû à l'installation elle-même, par exemple lorsque les appareils d'utilisation se trouvent en majorité raccordés à une phase particulière. On peut alors qualifier ce déséquilibre de structurel.

Le déséquilibre peut aussi être momentané, ou affecter tantôt telle phase, tantôt telle autre phase. On le qualifiera alors de conjoncturel.

Si les moments où il se manifeste son réguliers et concernent toujours la même phase, on dira qu'il s'agit d'un déséquilibre conjoncturel cyclique. Si par contre rien ne permet de les prévoir en époque ni phase, on sera en présence d'un déséquilibre conjoncturel aléatoire.

Les déséquilibres dits structurels peuvent être corrigés par une modification des raccordements sur l'installation, de façon à assurer en permanence une meilleure répartition de la puissance appelée sur les différentes lignes de phases.

Les déséquilibres conjoncturels cycliques peuvent être corrigés, par une modification de la programmation (automatique ou manuelle) de mise sous tension des appareils.

Les déséquilibres conjoncturels aléatoires ne peuvent être corrigés que grâce à des adaptateurs de puissance, et/ou des équilibreurs automatiques ; toutefois, le branchement de ces adaptateurs sur le réseau ne peut résulter que d'une meilleure connaissance du déséquilibre, et donc de l'existence d'un matériel d'analyse de celui-ci.

Comme on le verra plus loin en détail, le dispositif de surveillance de l'invention permet de détecter tout déséquilibre de la puissance électrique appelée sur les lignes conductrices des différentes phases d'un réseau alternatif en mesurant ou en calculant la valeur du courant dans la ligne neutre, et en effectuant le rapport de cette valeur, à la somme des valeurs des courants dans chacune des lignes de phase. Ce rapport qui peut être aussi qualifié de taux de déséquilibre, peut varier entre 0 et 1. Ce rapport présente la valeur 0 lorsque la valeur de l'intensité du courant dans la ligne neutre est nulle, et présente la valeur 1 lorsque toute la puissance est appelée sur une seule phase. La valeur du courant dans le centre est alors égale à l'intensité qui parcourt cette phase, le courant dans les deux autres phases étant nul.

En fait, on peut fixer à 0,5+ε la valeur limite du rapport ou taux de déséquilibre qu'il ne faut pas dépasser pour que le réseau fonctionne dans des conditions acceptables de déséquilibre. Pour cette valeur en effet, l'intensité du courant dans l'une des phases est toujours supérieure à la somme des intensités des courants de deux autres phases. Mais l'invention s'adapte à tout autre niveau de seuil que l'on se donnera. Les taux les plus riches d'enseignement sont toutefois supérieurs ou égaux à 0,5+ε .

L'invention a pour objet un dispositif de surveillance du déséquilibre de la puissance électrique appelée sur les lignes conductrices d'un réseau alternatif triphasé, ce réseau comprenant une ligne pour chaque phase et une ligne neutre de retour de courant, dispositif caractérisé en ce qu'il comporte des moyens de mesures de courants, reliés aux lignes du réseau pour fournir sur des sorties respectives, les valeurs numériques des courants circulant dans ces lignes, des moyens pour calculer la valeur du rapport, à un même instant, de la valeur du courant circulant dans la ligne neutre, à la somme des valeurs des courants circulant dans les lignes de phase, un signal numérique représentatif de la valeur de ce rapport étant fourni sur une sortie des moyens de calcul, des premiers moyens d'indication reliés à la sortie des moyens de calcul pour fournir une indication lorsque la valeur dudit rapport dépasse un seuil prédéterminé dit de déséquilibre, et des seconds moyens d'indication reliés aux sorties des moyens de mesure des courants dans les lignes de phase, ainsi qu'à une sortie des premiers moyens d'indication, pour repérer la ligne de phase dans laquelle circule alors un courant de valeur supérieure à chacune des valeurs des courants circulant dans les autres lignes de phase, la ligne repérée étant celle qui a causé le déséquilibre. Les moyens de calcul ne commandent l'indication d'un résultat que lorsque la puissance appelée dépasse une valeur de seuil Pₐ égale à X% (par exemple 75%) de la puissance assignée au réseau ou à l'installation. Il est en effet sans intérêt de suivre le déséquilibre d'une installation faiblement chargée. Le seuil de puissance totale à partir duquel on mémorise le taux de déséquilibre est proposé à 75%, mais on peut légitimement songer à une valeur réglable entre 50 et 90%.

Selon un mode de réalisation, les premiers moyens d'indication comportent deux détecteurs de seuil (puissance et déséquilibre) reliés à la sortie des moyens de calcul, une sortie du détecteur de déséquilibre étant reliée à un indicateur qui change d'état dès que ledit seuil prédéterminé est dépassé.

Selon un autre mode de réalisation, les troisièmes moyens d'indication comprennent un comparateur ayant des entrées reliées aux sorties des moyens de mesure des valeurs des courants dans les lignes de phase, pour déterminer à chaque instant la ligne de phase dans laquelle circule un courant dont la valeur est supérieure à celle des courants circulant dans les autres lignes de phase, ce comparateur ayant des sorties correspondant respectivement aux lignes de phase, un signal codé correspondant à la ligne dans laquelle circule le courant de plus forte valeur étant fourni sur la sortie correspondante du comparateur, un circuit logique de sélection ayant des entrées reliées aux sorties du comparateur et à la sortie des détecteurs de seuil, ce circuit logique de sélection ayant des sorties correspondant aux lignes de phase, ces sorties étant respectivement reliées à des indicateurs, ce circuit logique sélectionnant, dès que ledit seuil prédéterminé est dépassé, l'indicateur correspondant à la ligne dans laquelle circule le courant de valeur supérieure.

Selon un autre mode de réalisation, le dispositif comporte des moyens d'enregistrement reliés à la sortie des moyens de calcul et à la sortie du détecteur de seuil, pour enregistrer les valeurs desdits rapports, à chaque fois que le seuil prédéterminé est dépassé.

Selon un autre mode de réalisation, les moyens d'enregistrement sont reliés aux sorties des moyens de mesure des valeurs des courants dans les lignes de phase, et aux sorties du circuit logique de sélection, pour enregistrer à chaque dépassement du seuil prédéterminé, la valeur supérieure du courant dans la ligne de phase ayant causé le déséquilibre.

Les caractéristiques et avantages de l'invention ressortiront mieux de la description qui va suivre, donnée en référence à la figure annexée qui représente schématiquement un dispositif de surveillance de déséquilibre conforme à l'invention.

Le dispositif représenté schématiquement sur la figure permet de surveiller le déséquilibre de la puissance électrique appelée sur les lignes conductrices P1, P2, P3, PN d'un réseau électrique alternatif triphasé. Ce réseau comprend une ligne pour chacune des phases (les lignes P1, P2, P3, dans l'exemple choisi d'un réseau triphasé, ainsi qu'une ligne neutre PN de retour) du courant.

Le dispositif comporte des moyens 1 de mesure des courants, reliés aux lignes P1, P2, P3, PN du réseau, pour fournir sur des sorties, les valeurs numériques des courants circulant dans ces lignes. Ces moyens de mesures peuvent être constitués par exemple par des pinces ampèremétriques numériques, représentées respectivement en 2, 3, 4, 5 sur la figure. Il peut s'agir aussi de réducteurs d'intensité déjà en place pour l'alimentation de l'image thermique de l'éventuelle protection d'un transformateur. Ces pinces fournissent sur leurs sorties respectives 7, 8, 9, 10 les valeurs numériques des courants circulant dans les lignes correspondantes P3, P2, P1, PN. Comme PN peut être calculé à partir de P3, P2, P1 on a souvent avantage à remplacer la valeur de l'intensité dans la ligne PN par sa valeur calculée.

Le dispositif comprend aussi des moyens 11, pour calculer la valeur du rapport TD, à un instant déterminé, de la valeur du courant IN circulant dans la ligne neutre PN, à la somme I1+I2+I3 des valeurs des courants I1, I2, I3 circulant dans les lignes de phase P1, P2, P3.

Cette valeur TD égale à IN/I1+I2+I3 est qualifiée de rapport ou taux de déséquilibre du réseau. Elle est fournie sous forme d'un signal numérique sur une sortie 12 des moyens de calcul 11.

Le dispositif comprend aussi des premiers moyens d'indication 13 reliés à la sortie 12 des moyens de calcul 11, pour fournir une indication lorsque la valeur du rapport TD du déséquilibre du réseau, dépasse un seuil prédéterminé de déséquililibre. Cette valeur limite peut être, comme indiqué plus haut, fixée à 0,5+ε . Les premiers moyens d'indication 13 comprennent par exemple un détecteur de seuil 14, relié à la sortie 12 des moyens de calcul 11. Une sortie de ce détecteur est reliée à un indicateur 15 qui change d'état dès que le seuil prédéterminé TD de déséquilibre, est dépassé. L'indicateur 15 peut être une lampe ou un autre moyen acoustique ou électromécanique d'indication.

Le dispositif comporte aussi des seconds moyens 16 d'indication, reliés aux sorties 7, 8, 9 des moyens de mesure 2, 3, 4 des valeurs des courants dans les lignes de phase, ainsi qu'à une sortie de premiers moyens d'indication 13. En fait, cette sortie est celle du détecteur de seuil 14. Ce second moyen d'indication permet, comme on le verra plus loin en détail, de repérer la ligne de phase dans laquelle circule un courant de valeur supérieure à chacune des valeurs de courants circulant dans les autres lignes de phase. La ligne repérée est en effet celle qu'il conviendrait d'alléger par report sur les autres phases.

Les seconds moyens d'indication 16 comprennent un comparateur numérique 17, ayant des entrées reliées aux sorties 7, 8, 9 des moyens de mesure des valeurs des courants dans les lignes de phase ; ce comparateur permet de déterminer à chaque instant la ligne de phase dans laquelle circule un courant dont la valeur est supérieure à celle des courants circulant dans les autres lignes de phase. Le comparateur numérique n'est pas décrit ici en détail. Il peut être constitué par une association de comparateurs ; il fournit des signaux codés sur des sorties. Dans l'exemple considéré, où trois valeurs de courants sont à comparer, le comparateur comprend trois sorties. Un signal codé particulier est fourni sur la sortie du comparateur correspondant à la ligne de phase dans laquelle circule le courant pésentant la plus grande valeur. Ce signal codé peut être par exemple un signal de niveau logique 1 apparaissant sur la sortie concernée, les autres sorties fournissant des signaux de niveau logique 0.

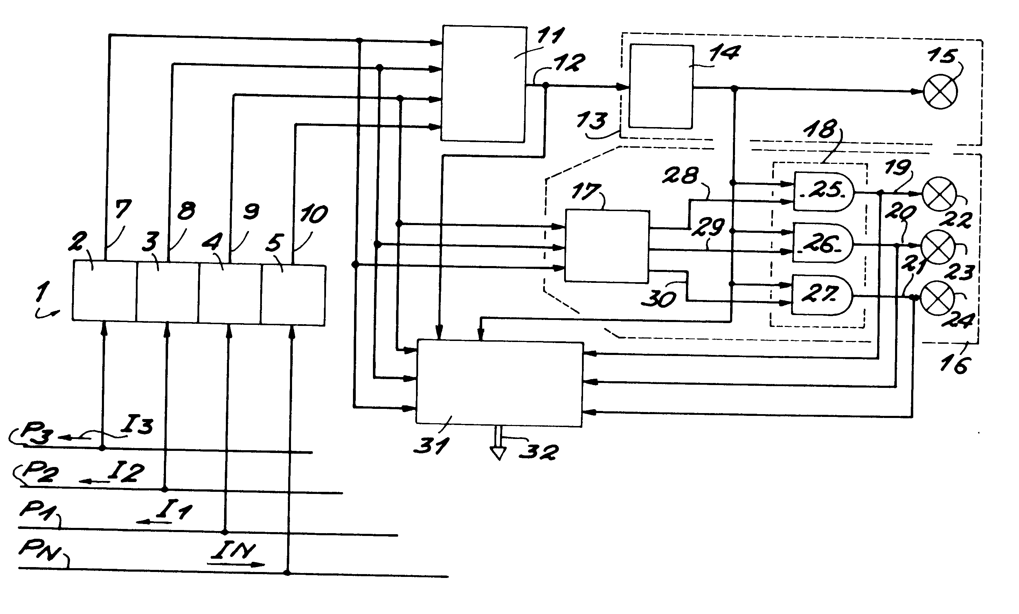

Les seconds moyens d'indication 16 comportent aussi un circuit logique de sélection 18 ayant des entrées reliées aux sorties du comparateur 17 ainsi qu'à la sortie du détecteur de seuil 14. Ce circuit logique de sélection présente des sorties correspondant respectivement aux lignes de phase. Ces sorties sont représentées en 19, 20, 21 sur la figure 1. Elles sont respectivement reliées à des indicateurs électriques ou électromécaniques 22, 23, 24. Le circuit logique de sélection 18 sélectionne, dès que le seuil prédéterminé est dépassé, l'indicateur correspondant à la ligne dans laquelle circule le courant de valeur la plus élevée.

Le circuit logique de sélection peut être constitué par exemple, dans le cas d'un réseau triphasé, par 3 portes 25, 26, 27 de type ET. Ces portes comprennent chacune deux entrées. Des premières entrées de ces portes sont respectivement reliées aux sorties 28, 29, 30 du comparateur 17, tandis que les secondes entrées de ces portes sont reliées à la sortie du détecteur de seuil 14.

Le dispositif qui vient d'être décrit fonctionne de la manière suivante : si un seuil de déséquilibre est dépassé, alors que la puissance totale appelée est supérieure à un certain niveau, l'indicateur 15 des premiers moyens d'indication 13 change d'état. Cet indicateur peut être par exemple une lampe qui s'allume. Si un seuil de déséquilibre est dépassé, c'est qu'il circule dans l'une des lignes de phase, un courant beaucoup plus important que dans les autres lignes, et que cette ligne causant le déséquilibre de la puissance appelée, doit être repéré. Si le courant le plus intense est le courant circulant dans la ligne P1, le comparateur 17 fournit sur sa sortie 30 correspondant à cette ligne un signal de niveau logique 1. En effet, ce comparateur repère la valeur numérique la plus élevée, fournie par la sortie 9 du moyen de mesure 4 du courant I1 circulant dans la ligne P1. Ce signal de niveau logique 1 est appliqué à la seconde entrée de la porte ET 27, tandis qu'un signal de niveau logique 1 est appliqué à la première entrée de cette porte, par la sortie du détecteur de seuil 14. Lorsque le rapport de déséquilibre TD (0,5+ε dans l'exemple considéré) , est dépassé, les sorties 28, 29 du comparateur fournissent un signal de niveau logique 0. La porte ET 27 fournit donc sur sa sortie 21 un signal de niveau logique 1 provoquant le changement d'état de l'indicateur électromécanique, électrique ou sonore 24, une lampe par exemple. Les autres indicateurs correspondant aux lignes P2, P3 ne changent pas d'état.

Ainsi, le dispositif permet de détecter le dépassement d'un taux ou rapport de déséquilibre prédéterminé lorsque la puissance totale P1+P2+P3 dépasse une certaine valeur de seuil P de puissance égale par exemple à 75% de la valeur assignée et de repérer la ligne de phase dans laquelle circule un courant de valeur supérieure à celle des valeurs des courants circulant dans les autres lignes de phase, la surintensité dans cette ligne ayant provoqué le déséquilibre de la puissance appelée sur le réseau.

L'indication de l'existence d'un déséquilibre concernant une phase est conservée tant qu'une intervention humaine n'a pas réarmé le dispositif. Mais pendant toute la période de raccordement du détecteur, les investigations se poursuivent et il n'est pas impossible qu'en relevé final, on constate que deux ou les trois phases ont été, à un moment ou l'autre, les plus chargées en situation de déséquilibre.

Si une seule phase a été concernée (déséquilibre structurel), la recommandation simple consiste à prévoir le transfert sur chacune des deux autres phases du quart de la charge de la première.

Si deux phases sont concernées, on peut suggérer le transfert du tiers de la charge de chacune sur la troisième, mais la bonne solution nécessite le plus souvent le recours à un analyseur de déséquilibre, seul susceptible d'indiquer si le phénomène est structurel ou conjoncturel.

Enfin, si les trois phases ont été à un moment ou l'autre concernées, on est certainement en présence de déséquilibres conjoncturels. L'analyse indique s'ils sont cycliques ou aléatoires et suggère les dispositions correctrices. A la limite, il faut se résoudre à envisager l'augmentation de la puissance du transformateur d'alimentation, ou de la puissance souscrite de l'abonnement de l'utilisateur.

Le dispositif comprend aussi des moyens d'enregistrement 31 reliés à la sortie 12 des moyens de calcul 11 et à la sortie du détecteur de seuil 14, pour enregistrer les valeurs des rapports de déséquilibre, à chaque fois que le seuil prédéterminé est dépassé. Ces moyens d'enregistrement peuvent être munis d'une horloge, non représentée, pour enregistrer en outre l'instant auquel se produit le déséquilibre, par rapport à un instant de référence.

Les moyens d'enregistrement 31 peuvent aussi être reliés aux sorties 7, 8, 9 des moyens de mesure 1 des valeurs de courant dans les lignes de phase P1, P2, P3, ainsi qu'aux sorties 19, 20, 21 du circuit logique de sélection 18. Ces liaisons permettent d'enregistrer à chaque dépassement du seuil prédéterminé, la valeur supérieure du courant dans la ligne de phase ayant provoqué le déséquilibre. L'instant d'enregistrement de cette valeur peut lui-même être enregistré, comme indiqué précédemment.

Les moyens d'enregistrement 31 peuvent être reliés par une sortie de lecture 32, à des moyens de visualisation (non représentés) des différentes valeurs enregistrées au cours du temps. Cette visualisation permet d'étudier par exemple, les lignes de phases provoquant les déséquilibres les plus importants, ainsi que le caractère structurel, conjoncturel cyclique ou aléatoire des déséquilibres. Cette étude permet, comme indiqué plus haut de remédier au déséquilibre de la puissance appelée, soit en connectant différemment les appareils alimentés par le réseau, soit en modifiant les caractéristiques du transformateur haute-basse tension alimentant ces appareils. Ce dispositif permet par exemple d'éviter d'utiliser des transformateurs de puissance trop importante. Il permet également, grâce à une meilleure répartition des appareils alimentés par les différentes lignes de phase du réseau, d'éviter toute interruption de ce réseau par suite d'un déséquilibre trop important sur l'une des lignes de phase de celui-ci. Il permet donc de réaliser des économies substantielles dans l'exploitation d'un réseau électrique alternatif polyphasé.

Des dispositions ont été prises pour éviter de considérer comme déséquilibre un réseau ou une installation qui ne l'a été que de façon fugitive.

De même, lorsque le réseau ou l'installation est protégé par un disjoncteur, il est prévu de signaler si le fonctionnement éventuel de celui-ci est intervenu en régime déséquilibré ou non.

## Revendications

1. Dispositif de surveillance du déséquilibre de la puissance électrique appelée sur les lignes conductrices (P1, P2, P3) d'un réseau électrique alternatif triphasé, ce réseau comprenant une ligne pour chaque phase et une ligne neutre (PN) de retour de courant, dispositif caractérisé en ce qu'il comporte des moyens (1) de mesures de courants reliés aux lignes (P1, P2, P3, PN) du réseau pour fournir sur des sorties respectives, les valeurs numériques des courants (I1, I2, I3, IN) circulant dans ces lignes, des moyens (11) pour calculer la valeur du rapport (TD), à un même instant, de la valeur du courant (IN) circulant dans la ligne neutre (PN), à la somme (I1+I2+I3) des valeurs des courants circulant dans les lignes de phases (P1, P2, P3), un signal numérique représentatif de la valeur de ce rapport (TD) étant fourni sur une sortie (12) des moyens de calcul (11), des premiers moyens (13) d'indication reliés à la sortie (12) des moyens de calcul (11) pour fournir une indication lorsque la valeur dudit rapport (TD) dépasse un seuil prédéterminé dit de déséquilibre, la puissance appelée au même moment étant elle-même supérieure à une certaine proportion de la puissance assignée et des seconds moyens (16) d'indication reliés aux sorties des moyens de mesure des courants (I1, I2, I3) dans les lignes de phase (P1, P2, P3), ainsi qu'à une sortie des premiers moyens d'indication (13), pour repérer la ligne de phase dans laquelle circule un courant de valeur supérieure à chacune des valeurs des courants circulant dans les autres lignes de phase, la ligne repérée étant celle qui a causé le déséquilibre.

2. Dispositif selon la revendication 1, caractérisé en ce que les premiers moyens d'indication (13) comportent un détecteur de seuil (14) relié à la sortie (12) des moyens de calcul (11), une sortie de ce détecteur étant reliée à un indicateur (15) qui change d'état dès que ledit seuil prédéterminé est dépassé.

3. Dispositif selon la revendication 2, caractérisé en ce que les seconds moyens d'indication (16) comprennent un comparateur (17) ayant des entrées reliées aux sorties (7, 8, 9) des moyens de mesure des valeurs des courants dans les lignes de phase (P1, P2, P3), pour déterminer à chaque instant, la ligne de phase dans laquelle circule un courant dont la valeur est supérieure à celle des courants circulant dans les autres lignes de phase, ce comparateur ayant des sorties (28, 29, 30) correspondant respectivement aux lignes de phase (P1, P2, P3), un signal codé correspondant à la ligne dans laquelle circule un courant de valeur supérieure étant fourni sur la sortie correspondante du comparateur, un circuit logique (18) de sélection ayant des entrées reliées aux sorties (28, 29, 30) du comparateur (17) et à la sortie du détecteur de seuil (14), ce circuit logique de sélection ayant des sorties (19, 20, 21) correspondant aux lignes de phase (P1, P2, P3), ces sorties étant respectivement reliées à des indicateurs (22, 23, 24), ce circuit logique sélectionnant, dès que ledit seuil prédéterminé est dépassé, l'indicateur correspondant à la ligne dans laquelle circule le courant de valeur supérieure.

4. Dispositif selon la revendication 3, caractérisé en ce qu'il comporte des moyens d'enregistrement (31) reliés à la sortie (12) des moyens de calcul (11) et à la sortie du détecteur de seuil (14), pour enregistrer les valeurs desdits rapports, à chaque fois que le seuil prédéterminé est dépassé.

5. Dispositif selon la revendication 4, caractérisé en ce que les moyens d'enregistrement (31) sont reliés aux sorties (7, 8, 9) des moyens de mesure des valeurs des courants (I1, I2, I3) dans les lignes de phase, et aux sorties (19, 20, 21) du circuit logique de sélection (18), pour enregistrer à chaque dépassement du seuil prédéterminé, la valeur supérieure du courant dans la ligne de phase ayant causé le déséquilibre.

## Patentansprüche

1. Überwachungsvorrichtung für die Unsymetrie der elektrischen Abnahmeleistung an den Stromleitern (P1, P2, P3) eines dreiphasigen Wechselstromnetzes, wobei dieses Netz einen Leiter für jede Phase und einen stromrückführenden Neutralleiter (PN) aufweist,
dadurch **gekennzeichnet**,
daß sie umfaßt,
Strommeßmittel (1), die an die Leitern (P1, P2, P3, PN) des Netzes angeschlossen werden, um an jeweiligen Ausgängen die numerischen Werte der in den Leitern fließenden Ströme (I1, I2, I3, IN) auszugeben, Mittel (11) für die zeitgleiche Berechnung des Werts des Verhältnisses (TD) von dem Wert des im Neutralleiter (PN) fließenden Stroms (IN) zu der Summe (I1+I2+I3) der Werte der in den Phasenleitern (P1, P2, P3) fließenden Ströme, wobei ein repräsentatives numerisches Signal des Werts dieses Verhältnisses (TD) an einem Ausgang (12) von Rechenmitteln (11) ausgegeben wird, erste Anzeigemittel (13), verbunden mit dem Ausgang (12) der Rechenmitteln (11), um eine Anzeige auszugeben, wenn der Wert des genannten Verhältnisses eine vorbestimmte sogenannte Unsymetrieschwelle überschreitet, wobei die abgenommene Leistung in denselben Moment um eine bestimmte Proportion größer ist als die zugeteilte Leistung und zweite Anzeigemittel (16), die mit den Ausgängen der Meßmittel der Ströme (I1, I2, I3, ) in den Phasenleitern (P1, P2, P3) verbunden sind sowie mit einem Ausgang der ersten Anzeigemittel (13), um den Phasenleiter kenntlich zu machen, in dem ein Strom fließt, dessen Wert größer ist als jeder der Werte der Ströme, die in den anderen Phasenleitern fließen, wobei der kenntlich gemachte Leiter jener ist, der die Unsymetrie verursacht hat.

2. Vorrichtung nach Anspruch 1, dadurch gekennzeichnet, daß die ersten Anzeigemittel (13) einen Schwellendetektor (14) enthalten, der mit dem Ausgang (12) der Rechenmittel (11) verbunden ist, wobei ein Ausgang dieses Detektors verbunden ist mit einer Anzeige (15), die ihren Zustand ändert sobald die vorbestimmte Schwelle überschritten wird.

3. Vorrichtung nach Anspruch 2, dadurch gekennzeichnet, daß die zweiten Anzeigemittel (16) ein Differenzierglied (17) enthalten, dessen Eingänge verbunden sind mit den Ausgängen (7, 8, 9) der Meßmittel der Werte der Ströme in den Phasenleitern (P1, P2, P3), um zu jedem Zeitpunkt den Phasenleiter zu bestimmen, in dem ein Strom fließt, dessen Wert höher ist als der der in den anderen Phasenleitern fließenden Ströme, wobei dieses Differenzierglied Ausgänge (28, 29, 30) hat, die jeweils den Phasenleitern (P1, P2, P3) entsprechen, wobei ein codiertes Signal, entsprechend dem Leiter in dem ein Strom mit einem höheren Wert fließt, ausgegeben wird am entsprechenden Ausgang des Differenzierglieds, wobei ein Auswahllogik-Schaltkreis (18) Eingänge hat, die mit den Ausgängen (28, 29, 30) des Differenzierglieds (17) verbunden sind und mit dem Ausgang des Schwellendetektors (14), wobei dieser Auswahllogik-Schaltkreis Ausgänge (19, 20. 21) hat, die den Phasenleitern (P1, P2, P3) entsprechen, wobei diese Ausgänge jeweils verbunden sind mit den Anzeigen (22, 23, 24), wobei dieser Logikschaltkreis, sobald die genannte vorbestimmte Schwelle überschritten wird, die Anzeige auswählt, die dem Leiter entspricht, in dem der Strom mit dem höheren Wert fließt.

4. Vorrichtung nach Anspruch 3, dadurch gekennzeichnet, daß sie Aufzeichnungsmittel (31) enthält, die mit dem Ausgang (12) der Rechenmittel (11) verbunden sind und mit dem Ausgang des Schwellendetektors (14), um die Werte der genannten Verhältnisse jedesmal aufzuzeichnen, wenn die vorbestimmte Schwelle überschritten wird.

5. Vorrichtung nach Anspruch 4, dadurch gekennzeichnet, daß die Aufzeichnungsmittel (31) verbunden sind mit den Ausgängen (7, 8, 9) der Meßmittel der Werte der Ströme (I1, I2, I3) in den Phasenleitern, und mit den Ausgängen (19, 20, 21) des Auswahllogik-Schaltkreises (18), um bei jedem Überschreiten der vorbestimmten Schwelle den höheren Wert des Stroms in dem Phasenleiter, der die Unsymetrie verursacht, aufzuzeichnen.

## Claims

1. Device to monitor the unbalance of the electric power demanded on the conductive lines of a three-phase alternating network, this network including one line for each phase and a return current dead line (PN), characterized in that it comprises means (1) to measure the currents connected to the lines (P1,P2,P3,PN) of the network so as to supply on respective outputs the numerical values of the currents (I1,I2, I3,IN) circulating in these lines, means to calculate the value of the ratio (TD), at a given instant of the value of the current (IN) circulating in the dead line (PN), to the sum (I1+I2+I3) of the values of the currents circulating in the phase lines (P1,P2,P3), a numerical signal representative of the value of this ratio (TD) being supplied on one output (12) of the calculation means (11), first indication means (13) connected to the output (12) of the calculation means (11) so as to indicate when the value of said ratio (TD) exceeds a predetermined unbalance threshold, the power demanded at the same moment itself being greater than a certain proportion of the power assigned, and second indication means (16) connected to the outputs of the means for measuring the currents (I1,I2,I3) in the phase lines (P1,P2,P3) and to one output of the first indication means (13) so as to localize the phase line in which a current is circulating whose value is greater than each of the values of the currents circulating in the other phase lines, the localized line being the one which has caused the unbalance.

2. Device according to claim 1, characterized in that the first indication means (13) comprise a threshold detector (14) connected to the output (12) of the calculation means (11), one output of this detector being connected to an indicator (15) which changes state as soon as said predetermined threshold is exceeded.

3. Device according to claim 2, characterized in that the second indication means (16) comprise a comparator (17) having inputs connected to the outputs (7,8,9) of the means for measuring the values of the currents in the phase lines (P1,P2,P3) so as to determine at each instant the phase line in which a current is circulating whose value is greater than the value of the currents circulating in the other phase lines, this comparator having outputs (28,29, 30) respectively corresponding to the phase lines (P1,P2,P3), a coded signal, corresponding to the line in which a current of greater value is circulating, being supplied on the corresponding output of the comparator, a selective logic circuit (18) having inputs connected to the outputs (28,29, 30) of the comparator (17) and to the output of the threshold detector (14), this selective logic circuit having outputs (19,20,21) corresponding to the phase lines (P1,P2,P3), these outputs respectively being connected to indicators (22,23,24), this logic circuit, as soon as said predetermined threshold is exceeded, selecting the indicator corresponding to the line in which the higher value is circulating.

4. Device according to claim 3, characterized in that it comprises recording means (31) connected to the output (12) of the calculation means (11) and to the output of the threshold detector (14) so as to record the values of said ratios each time the predetermined threshold is exceeded.

5. Device according to claim 4, characterized in that the recording means (31) are connected to the outputs (7,8,9) of the means for measuring the values of the currents (I1,I2,I3) in the phase lines, and to the outputs (19,20,21) of the selective logic circuit (18) so as to record, on each occasion the predetermined threshold is exceeded, the upper value of the current in the phase line having caused this unbalance.
